# EUROPÄISCHE PATENTSCHRIFT

(11) **EP 2 898 759 B1**
(45) Veröffentlichungstag und Bekanntmachung des Hinweises auf die Patenterteilung: **27.11.2019**
(21) Anmeldenummer: 13756878.8
(22) Anmeldetag: 30.08.2013
(51) Int. Cl.: H05K 3/10, H05K 3/46, H05K 3/38

(54) **VERFAHREN ZUR HERSTELLUNG EINES LEITERPLATTENELEMENTS SOWIE LEITERPLATTENELEMENT**
METHOD FOR PRODUCING A CIRCUIT BOARD ELEMENT, AND CIRCUIT BOARD ELEMENT
PROCÉDÉ DE FABRICATION D'UN ÉLÉMENT DE CARTE DE CIRCUIT IMPRIMÉ ET ÉLÉMENT DE CARTE DE CIRCUIT IMPRIMÉ

(30) Priorität: 20.09.2012 DE 102012216926
(43) Veröffentlichungstag der Anmeldung: 29.07.2015
(73) Patentinhaber: JUMATECH GmbH, 90542 Eckental (DE)
(72) Erfinder: WÖLFEL, Markus, 91207 Lauf (DE)
(74) Vertreter: Grünecker Patent- und Rechtsanwälte PartG mbB
(86) Internationale Anmeldenummer: PCT/EP2013/067988
(87) Internationale Veröffentlichungsnummer: WO 2014/044515

(56) Entgegenhaltungen:
- DE-A1-102005 024 347
- DE-U1-202005 001 161
- JP-A- H1 174 625
- US-A1- 2006 263 936
- US-A1- 2007 143 993
- US-A1- 2009 081 426
- US-A1- 2010 327 044

## Beschreibung

Die Erfindung betrifft ein Verfahren zur Herstellung eines Leiterplattenelements, bei dem zunächst ein Bauelement aus einem elektrisch leitenden Werkstoff bereitgestellt und dieses Bauelement mit einer elektrisch leitenden Folie an wenigstens einer Kontaktstelle kontaktiert wird, wobei das Kontaktieren des Bauelements mit der Folie durch Schweißen erfolgt, bevor anschließend eine Deckschicht auf die das Bauelement kontaktierende Seite der Folie aufgebracht wird.

Desweiteren bezieht sich die Erfindung auf ein Leiterplattenelement mit zumindest einer elektrisch leitenden Folie, mit einer Deckschicht, die die Folie auf zumindest einer Seite abdeckt, und mit zumindest einem Bauelement aus einem elektrisch leitenden Werkstoff, wobei das Bauelement an wenigstens einer Kontaktstelle mit der Folie verschweißt ist und zumindest abschnittsweise, vorzugsweise vollständig, in die Deckschicht eingebettet ist.

In der JP H11 74625 A wird ein Verfahren zur Herstellung einer mehrlagigen Leiterplatte (Multilayer) offenbart, bei der die Verbindungen zwischen den einzelnen Lagen mit Durchkontaktierungen ("VIAs") hergestellt werden. Zunächst wird eine Metallfolie bereitgestellt, die auf einer als Zwischenträger dienenden Transferfolie aufgeklebt ist, wobei mittels eines nachfolgenden Ätzprozesses aus der Metallfolie eine Metallschicht mit einem gewünschten Leiterbahnmuster gebildet wird. Anschließend wird die geätzte Metallschicht einer Oberflächenaufrauung unterzogen, sodass die Seitenflächen und Stirnflächen der in der Metallschicht gebildeten Leiterbahnen eine definierte Oberflächenrauigkeit aufweisen. Abschließend wir die in vorgeschilderter Weise behandelte Metallschicht auf ein Prepreg übertragen, um eine Lage des Multilayers zu bilden.

Die US 2009/081426 A1 offenbart ein Verfahren zur Herstellung einer beschichteten flexiblen Platte, welche aus einem Laminat gebildet ist, das einen Harzfilm und eine auf der Oberfläche des Harzfilms angeordnete Metallfolie umfasst. Um die Haftkraft zwischen Metallfolie und Harzfilm weiter zu erhöhen, kann die Oberfläche der Metallfolie mechanisch oder chemisch aufgeraut werden.

Der Trend zu immer kleineren und zugleich immer leistungsfähigeren elektronischen Geräten, wie zum Beispiel bei Smartphones oder Tablets, führt schon seit Jahren zu einer steigenden Integrationsdichte auf Leiterplatten.

Einen deutlichen Vorteil zeigen in dieser Hinsicht drahtbeschriebene Leiterplatten, bei denen Leitungsdrähte auf die Ober- und/oder Unterseite einer Kupferfolie aufgebracht werden. Nach dem Verpressen der Folie mit einer elektrisch isolierenden Deckschicht, üblicherweise einem Prepreg aus einem Epoxidharz-Glasfasergewebe, befinden sich die Drähte im Inneren des Laminates, eingebettet in das Prepreg.

Durch diese beispielsweise in der WO 2008/055672 A1 oder in der DE 20 2005 001161 U1 beschriebene Drahtschreibetechnik lassen sich in Leiterplatten dreidimensionale Schaltungsgeometrien für extreme Packungsdichten realisieren. Wenngleich hierdurch viele technische Einschränkungen der herkömmlichen Leiterplattentechnik überwunden werden, sind drahtbeschriebene Leiterplatten hinsichtlich ihrer Delaminationsfestigkeit noch verbesserungsfähig.

Die Delamination von Leiterplattenelementen ist eine ernstzunehmende Herausforderung, zumal insbesondere mehrlagige Leiterplatten (Multilayer) immer größer werdenden thermischen und/oder mechanischen Belastungen ausgesetzt sind.

Die Haftwerte zwischen den einzelnen Lagen des Multilayers, also zwischen den einzelnen Kupferfolien und den jeweils zwischengefügten Prepreg-Schichten (Epoxidharz-Glasfasergewebe-Schichten), konnte dabei in den vergangenen Jahren durch eine vorgelagerte Behandlung der Oberfläche der Kupferfolien mit chemischen Mitteln ("Braunoxid"- oder "Schwarzoxid"-Behandlung) und durch die Verwendung verbesserter Epoxidharzmischungen für Prepregs erheblich erhöht werden.

Die Einbettung zusätzlicher Bauelemente in die Prepreg-Schichten der Leiterplatte führt jedoch zu eine Erhöhung der Delaminationsgefahr, da sich die Delamination zunächst an den "Schwachstellen" zwischen den Oberflächen der eingebetteten Bauelemente und dem umgebenden Prepreg und nicht an der deutlich haftfesteren Verbindung zwischen der behandelten Kupferfolienoberfläche und dem Prepreg bemerkbar macht.

Insbesondere in drahtbeschriebenen Leiterplatten erfolgt durch die im Prepreg eingebetteten Leitungsdrähte eine Schwächung des Haftverbundes.

Verstärkt wird dieses Problem noch dadurch, dass die in das Innere der Leiterplatte zusätzlich eingebrachten Drähte als versilberte Kupferdrähte ausgeführt sein können. Zwar weist die auf den Kupferkern galvanisch aufgebrachte Silberschicht nicht nur eine sehr gute Leitfähigkeit auf, sondern ist insbesondere auch sehr gut schweißbar. Neben den wirtschaftlichen Nachteilen (versilberte Kupferdrähte sind um ein vielfaches teurer als reine Kupferdrähte) weist die Silberschicht jedoch aufgrund ihrer verhältnismäßig glatten Oberfläche nur eine sehr schlechte Haftung zu der sie umgebenden Schicht aus Prepreg auf.

Demzufolge ist es nun Aufgabe der vorliegenden Erfindung, ein Verfahren zur Herstellung eines Leiterplattenelements bzw. ein Leiterplattenelement anzugeben, das eine ausgezeichnete Haftung zwischen den zusätzlich im Leiterplattenelement integrierten Bauelementen (in Form von Leitungsdrähten oder plattenförmigen Formteilen) und der sie jeweils umgebenden Deckschicht ermöglicht, so dass keine Delaminierung des Leiterplattenelements im Bereich der in der Deckschicht eingebetteten Bauelemente (in Form von Leitungsdrähten oder plattenförmigen Formteilen) stattfindet.

Diese Aufgabe wird gemäß Patentanspruch 1 durch ein Verfahren zur Herstellung eines Leiterplattenelements gelöst, bei dem die Oberfläche des Leitungsdrahts oder plattenförmigen Formteils vor dem Aufbringen der Deckschicht zumindest teilweise aufgeraut wird, so dass beim Aufbringen der Deckschicht auf die Folie die Deckschicht mit der aufgerauten Oberfläche des Leitungsdrahts oder plattenförmigen Formteils in Kontakt gebracht wird.

Indem das im Leiterplattenelement eingebettete Bauelement (in Form eines Leitungsdrahts oder plattenförmigen Formteils) anstatt einer vergleichsweise glatten Oberfläche, zum Beispiel anstatt einer glatten Silbermetall-Oberfläche, eine zumindest teilweise aufgeraute Oberfläche aufweist, wird eine deutlich bessere Haftung zwischen dem Bauelement und der das Bauelement umgebenden Deckschicht sichergestellt. Somit können problemlos Bauelemente in einen Multilayer integriert werden, ohne dass es ausgehend von einem Ablösen des Bauelements von der angrenzenden Deckschicht zu einer Delamination der Leiterplatte kommt. Somit eröffnen sich für Leiterplatten mit eingebetteten Bauelementen (unter anderem in Form von drahtbeschriebenen Leiterplatten) neue Einsatzgebiete, die aufgrund ihrer extremen Umgebungsbedingungen bisher als kaum realisierbar erschienen, zum Beispiel der Einsatz in Hochtemperaturanwendungen, beispielsweise in der Automobilelektronik.

Bevorzugterweise erfolgt beim erfindungsgemäßen Verfahren das Aufrauen der Oberfläche des Leitungsdrahts oder plattenförmigen Formteils vor dem Kontaktieren des Leitungsdrahts oder plattenförmigen Formteils mit der Folie. Die aufgeraute Oberfläche des Leitungsdrahts oder plattenförmigen Formteils hat keinerlei negativen Einfluss auf die Güte der zwischen Bauelement (Leitungsdraht oder plattenförmigem Formteil) und Folie (beispielsweise durch Widerstandsschweißen) herzustellenden Kontaktierung, so dass mit geringem Aufwand und bei hohem, kontinuierlichen Durchsatz die gesamte Oberfläche der Bauelemente einer vorgelagerten Aufrauungsbehandlung unterzogen werden kann.

Insbesondere kann das Aufrauen der Oberfläche des Leitungsdrahts oder plattenförmigen Formteils durch chemisches Ätzen realisiert werden, wobei das chemische Ätzen vorzugsweise durch Eintauchen des Leitungsdrahts oder plattenförmigen Formteils in eine das Material des Leitungsdrahts oder plattenförmigen Formteils ätzende Flüssigkeit oder durch das Besprühen des Leitungsdrahts oder plattenförmigen Formteils mit einer solchen Flüssigkeit erfolgt. Vor dem eigentlichen Mikroätzprozess werden die zu behandelnden Leitungsdrähte oder plattenförmige Formteile gereinigt und deren Metalloberflächen dabei durch eine saure oder alkalische Lösung entfettet (Cleaner). Nach dem Mikroätzprozess, der beispielsweise in einem Flutmodul mit Schwalldüsen (Bond) durchgeführt werden kann, werden Restrückstände der ätzenden Flüssigkeit in einem Kaskaden-Spülmodul entfernt, bevor die Leitungsdrähte oder plattenförmige Formteile schließlich fleckenfrei getrocknet werden.

Alternativ kann die Oberfläche des Leitungsdrahts oder plattenförmigen Formteils auch durch mechanisches Bearbeiten, zum Beispiel durch Sandstrahlen oder durch das Aufsprühen von Bims- oder Quarzmehl unter hohem Druck, aufgeraut und so haftfähiger gemacht werden. Mechanische Aufrauverfahren haben den Vorteil, dass die Oberflächenrauigkeit allein durch mechanischen Abtrag hergestellt wird, so dass auf die Verwendung aggressiver Ätzlösungen, welche teuer in Anschaffung und Entsorgung sind, verzichtet werden kann.

In weiter bevorzugter Weise erfolgt das Aufbringen einer Deckschicht auf die den Leitungsdraht oder das plattenförmige Formteil kontaktierende Seite der Folie durch Verpressen der Seite der Folie mit einem Prepreg aus Isolierstoffmasse. Das Verpressen geschieht in der Weise, dass die mit dem Leitungsdraht oder plattenförmigen Formteil bestückte Kupferfolie und das Prepreg (Epoxidharz-Glasfasergewebe-Zuschnitt) in eine Laminatpresse eingeführt und nach Druck- und Wärmeeinwirkung als verpresstes Endprodukt das Leiterplattenelement ausgestoßen wird, welches mit den etablierten Prozessen (Ätzprozess von außen und Bestücken mit SMD-Bauteilen) fertiggestellt werden kann.

Vorzugsweise werden eine Mehrzahl von elektrisch leitfähigen Folien, von denen mindestens eine mit mindestens einem Leitungsdraht oder plattenförmigen Formteil aus einem elektrisch leitenden Werkstoff kontaktiert ist, und eine Mehrzahl von jeweils zwischen den Folien eingefügten Prepregs aus Isolierstoffmasse miteinander zu einem Multilayer-Leiterplattenelement verpresst. Insbesondere bei einer solchen Verpressung zum Multilayer muss zwischen jeder Schichtlage eine ausreichende interlaminare Haftung sichergestellt sein, da bereits einzelne lokale Abhebungen, wie sie durch im Prepreg eingebettete Leitungsdrähte oder plattenförmige Formteile hervorgerufen werden können, zu einer Delamination und damit zum Totalausfall des Multilayer-Leiterplattenelements führen können.

Die der Erfindung zugrunde liegende Aufgabe wird darüber hinaus gemäß Patentanspruch 8 durch ein Leiterplattenelement der eingangs genannten Art gelöst, bei dem zumindest ein Teil der mit der Deckschicht in Kontakt stehenden Oberfläche des Leitungsdrahts oder plattenförmigen Formteils aufgeraut ist. Durch die mikrofeine Aufrauung der Oberfläche des Leitungsdrahts oder plattenförmigen Formteils entsteht die ideale Oberflächentopographie für die optimale Haftung von Leitungsdraht oder plattenförmigem Formteil und umgebender Deckschicht, so dass die vom eingebetteten Leitungsdraht oder plattenförmigen Formteil ausgehende Gefahr der Delamination des Leiterplattenelements nahezu ausgeschlossen werden kann.

Bei dem auf die zu verpressende Folie, insbesondere Kupferfolie, aufgebrachten Leitungsdraht kann es sich insbesondere um einen Kupferdraht handeln, der nach dem Verpressen im Inneren des Leiterplattenelements angeordnet ist und über geätzte Pads von außen kontaktiert wird (sogenannte drahtbeschriebene Leiterplatten).

Ein sich im Leiterplattenelement erstreckendes, plattenförmiges Formteil kann insbesondere als Kupferformteil ausgebildet sein, wobei mittels eines solchen Formteils beispielsweise die erforderlichen Leitungsquerschnitte zur Beherrschung der im Bereich der Leistungselektronik auftretenden Ströme und Wärmemengen aufwandsarm bereitgestellt werden können.

Die Erfindung wird nun nachfolgend unter Bezugnahme auf zwei Figuren noch weiter erläutert. Es zeigen im Einzelnen:

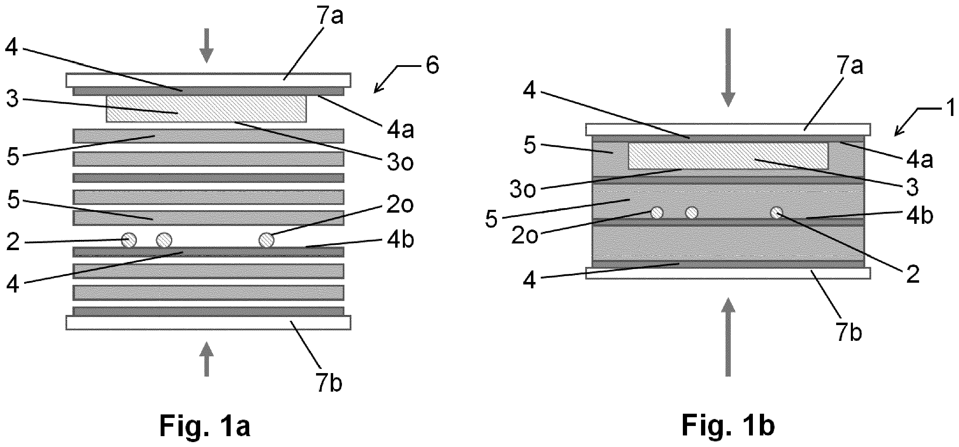

- Figur 1a: eine schematische Querschnittsansicht der Lagen eines Multilayer-Leiterplattenelements gemäß der Erfindung, wie sie im unverpressten Zustand aufeinanderliegen,
- Figur 1b: eine schematische Querschnittsansicht eines Multilayer-Leiterplattenelements gemäß der Erfindung im verpressten Zustand.

In den Figuren 1a und 1b sind jeweils in Querschnittsansicht die einzelnen Materiallagen eines erfindungsgemäßen Leiterplattenelements 1 zur besseren Unterscheidung mit anderer Flächenfüllung dargestellt. Mit jeweils schräger Schraffierung sind die Bauelemente 2, 3 dargestellt, die in das Leiterplattenelement 1 eingebettet werden. Mit dunklem Vollton sind die Kupferfolien 4 gezeigt, während in hellem Vollton die Epoxidharz-Glasfasergewebe-Schichten 5, nachstehend allgemein Prepreg genannt, im Querschnitt zu sehen sind.

Die Bauelemente, bei denen es sich zum einen um drei kreiszylindrische Kupferdrähte 2 und zum anderen um ein plattenförmiges Kupferformteil 3, z. B. in Form eines Kupferflachdrahts, handelt, sind in einem vorgelagerten Verfahrensschritt jeweils auf die Seite 4a, 4b einer Kupferfolie 4 fixiert worden. Dieser in den Figuren nicht dargestellte Verfahrensschritt des Fixierens der Bauelemente 2, 3 an den Kupferfolien 4 wird mittels einer bereits in der WO 2006/077167 A2 beschriebenen, numerisch gesteuerten Vorrichtung zum stoffschlüssigen Verbinden durchgeführt, wobei das Verbinden vorzugsweise an definierten Kontaktstellen mittels Widerstandspunktschweißen erfolgt. Die Drähte 2 werden dabei aktiv nachgeführt, in einer definierten Sollposition niedergehalten, geschnitten und mittels einer ebenfalls kontrolliert verfahrbaren Schweißelektrode verschweißt.

Als Formteil 3 im Sinne dieser Erfindung wird vorzugsweise ein Bauteil bezeichnet, das in einem Trennverfahren hergestellt ist, in welchem die Form eines Werkstücks verändert wird, wobei das Formteil 3 von dem Werkstück abgetrennt wird und die Endform in der Ausgangsform enthalten ist. In den Figuren 1a und 1b ist die obere Kupferfolie 4 an ihrer Unterseite 4a mit einem aus einer Kupferplatte herausgetrennten, plattenförmigen Formteil 3 versehen, wobei Kupferfolie 4 und Formteil 3 ebenfalls an genau definierten Anschlussstellen durch ein stoffschlüssiges Verbindungsverfahren, wie zum Beispiel durch Widerstandspunktschweißen, miteinander kontaktiert worden sind.

In Figur 1a ist die Querschnittsansicht eines Zwischenprodukts in dem Verfahren zur Herstellung des erfindungsgemäßen Multilayer-Leiterplattenelements 1 zu sehen. Dieses Zwischenprodukt zeigt den Aufbau eines Schichtstapels 6 aus mehreren übereinander angeordneten elektrisch isolierenden Schichten aus Prepreg 5 und mehreren leitenden Schichten aus Kupferfolie 4, wobei diese Schichten nur zur besseren Veranschaulichung mit vertikalem Abstand voneinander dargestellt worden sind. Zwei der Kupferfolien 4 sind gemäß dem vorgeschilderten Verfahrensschritt auf einer Seite 4a, 4b mit zusätzlichen Bauelementen (Drähten 2 bzw. Formteil 3) bestückt worden, wobei diese beiden Kupferfolien 4 im Schichtstapel 6 so orientiert sind, dass die das Bauelement 2, 3 kontaktierende Folienseite 4a, 4b in das Innere des Schichtstapels 6 weist, so dass die Bauelemente 2, 3 nach dem Verpressen immer im Inneren des Leiterplattenelements 1 zu liegen kommen.

Der vorstehend beschriebene Schichtstapel 6 ist gemäß Figur 1a zwischen die Pressplatten 7a, 7b einer Laminatpresse eingebracht, wobei anschließend gemäß Figur 1b ein Druck (siehe aufeinander zu gerichtete Pfeile in Figuren 1a und 1b) mittels der Pressplatten 7a, 7b auf die miteinander zu laminierenden Schichten des Leiterplattenelements 1 aufgebracht und dabei gleichzeitig die Temperatur der zu laminierenden Schichten auf eine gewünschte Temperatur oberhalb der Raumtemperatur erhöht wird.

Es sei angemerkt, dass der durch den Übergang von Figur 1a nach Figur 1b illustrierte Pressvorgang in stark vereinfachter Weise wiedergegeben worden ist. Die Herstellung eines Multilayer-Leiterplattenelements 1 erfolgt in der Praxis nämlich mittels eines mehrstufigen Prozesses. Demnach werden zunächst die mittleren Lagen des Schichtstapels 6 mit zwischen einer unteren und einer oberen Kupferfolie 4 platzierten Schichten aus Prepreg 5 zu einem Zwischenprodukt verpresst. Daraufhin werden die äußeren Kupferfolien 4 dieses Zwischenprodukts in bekannter Weise zunächst von außen geätzt. Auf die geätzten Kupferfolien 4 werden weitere Schichten aus Prepreg 5 und abschließende Kupferfolien 4 aufgetragen. Dieser nicht dargestellte Stapel aus bereits verpresstem Zwischenprodukt und zusätzlichen äußeren Lagen wird schließlich zum fertigen Multilayer-Leiterplattenelement 1 gepresst.

Das jeweils zwischen die Kupferfolien 4 eingefügte Prepreg 5 besteht aus einem epoxidharzgetränkten Glasfasergewebe als Isolierstoffmasse, die unter der vorbeschriebenen Druck- und Wärmeeinwirkung plastifiziert wird und beim anschließenden Aushärten eine Verklebung mit den angrenzenden Kupferfolien 4 bewirkt. Das an der Unterseite 4a der oberen Kupferfolie 4 angebrachte, plattenförmige Formteil 3 wird beim Verpressen derart in die Isolierstoffmasse des Prepregs 5 eingebettet, dass alle Seiten des Formteils 3 vollflächig mit der Isolierstoffmasse des Prepregs 5 bedeckt sind. Allein die zwischen Formteil 3 und Kupferfolie 4 vorgesehene, mindestens eine Kontaktstelle ist nicht vom Prepreg 5 umschlossen. Die kreiszylindrischen Leitungsdrähte 2 werden beim Verpressen ebenfalls nahezu vollumfänglich in die Isolierstoffmasse des Prepregs 5 eingebettet. Auch hier ist allein die mindestens eine Kontaktstelle zwischen dem jeweiligen Draht 2 und der Kupferfolie 4 nicht vom Prepreg 5 bedeckt.

Für eine bessere Haftung zwischen Prepreg 5 und Kupferfolie 4 ist es bekannt, die Oberflächen der Kupferfolien 4 durch einen Oxidationsprozess ("Braunoxid" bzw. "Schwarzoxid") vorzubehandeln, so dass beim anschließenden Verpressen gemäß Figur 1b zum Multilayer-Leiterplattenelement 1 ein besserer Haftverbund zwischen den Kupferfolien 4 und den isolierenden Deckschichten 5 (Prepregs) gewährleistet werden kann. Das gemäß der vorliegenden Erfindung aufgebaute Leiterplattenelement 1 weist jedoch besondere Herausforderungen hinsichtlich der Delaminationsfestigkeit auf, da durch die zusätzlich in die Isolierstoffmasse des Prepregs 5 eingebetteten Bauelemente 2, 3 eine Schwächung des Haftverbundes des Leiterplattenelements 1 eintritt. Im Gegensatz zu den Kupferfolienoberflächen weisen die Bauelementoberflächen 2o, 3o nämlich nur eine sehr schwache Haftung an dem jeweils angrenzenden Prepreg 5 auf.

Der Grund dafür liegt unter anderem darin, dass in drahtbeschriebenen Leiterplatten (d. h. Leiterplatten, deren Kupferfolien 4 mit Drähten 2 verschweißt sind) zumeist galvanisch versilberte Kupferdrähte als eingebettete Bauelemente zum Einsatz gelangen. Die äußere Silberschicht dieser Drähte weist zwar sehr gute Schweißeigenschaften zur Erzielung einer sicheren Verbindung mit der Kupferfolie 4 auf, jedoch ist die Haftung der Silberschicht zum umgebenden Prepreg 5 bedingt durch die eher glatte Oberfläche der Silberschicht unzureichend. In der Folge kann es zu lokalen Abhebungen der Silberschicht des Bauelements vom umgebenden Prepreg 5 kommen, die im Extremfall zum Ausgangspunkt einer vollständigen Delamination und somit eines Totalausfalls des Leiterplattenelements 1 werden können.

Hier setzt die vorliegende Erfindung an und beseitigt das Problem der schlechten Haftung von eingebettetem Bauelement 2, 3 und umgebender Schicht aus Prepreg 5 dadurch, dass die mit dem Prepreg 5 in Kontakt stehende Oberfläche 2o, 3o des Bauelements 2, 3 zumindest teilweise aufgeraut ist. "Aufgeraut" bedeutet hierbei, dass die Oberfläche 2o, 3o des Bauelements 2, 3 vor dem Aufbringen der Deckschicht 5 auf die Kupferfolie 4 und dem dabei erfolgenden Einbetten des Bauelements 2, 3 in diese Deckschicht 5 einer gezielten Aufrauungsbehandlung unterzogen worden ist, um die Oberfläche 2o, 3o mit einer definierten Mikrorauigkeit zu versehen. Da diese Mikrorauigkeit keine wesentlichen Auswirkungen auf die Qualität der Schweißverbindungen zwischen Bauelementen 2, 3 und Kupferfolien 4 hat, können die Bauelemente 2, 3 bereits in ihrem Halbfertigzustand als Draht- oder Plattenware in großer Durchsatzgeschwindigkeit aufwandsarm vorbehandelt werden, bevor sie dem eigentlichen Leiterplattenherstellungsprozess zugeführt werden.

Die Aufrauungsbehandlung kann eine chemische Aufrauung sein, wobei die Bauelementoberfläche 2o, 3o in einem mehrstufigen Tauch- und/oder Sprühverfahren mit einer ätzenden Lösung in Berührung gebracht wird und das Oberflächenmaterial dabei teilweise weggeätzt wird, oder kann eine mechanische Aufrauung sein, wobei die Bauelementoberfläche 2o, 3o mechanischen Kräften unterzogen wird.

Die chemische Aufrauung erfolgt vorteilhafterweise in mehrstufigen Anlagen mit mehreren in Reihe geschalteten Modulen, wobei die Oberflächen 2o, 3o der kontinuierlich durch die Anlage geführten Bauelemente 2, 3 vor dem eigentlichen Mikroätzprozess zumeist noch gereinigt, gespült und vorgetaucht werden und nach dem Mikroätzprozess ein neuerliches Spülen zum Entfernen der ätzenden Lösungsrückstände stattfindet. Die mechanische Aufrauung kann zum Beispiel durch Verwendung einer dichten Masse winziger Kugeln aus zum Beispiel Stahl, Glas, Bims-, Quarzmehl oder ähnlichem oder über Bürstenaufrauungstechniken erzeugt werden. Ebenfalls denkbar wäre es, die Aufrauung durch das Einbringen einer einfachen Profilierung (z. B. von Kerbungen) in die Bauelementoberfläche 2o, 3o zu erzielen.

Durch die aufgeraute Oberfläche 2o, 3o des Bauelements 2, 3 erhält die das Bauelement 2, 3 kontaktierende Schicht des Prepregs 5 nach dem Verpressen und Aushärten eine entsprechende Rauheit, die komplementär zur Rauheit der Bauelementoberfläche 2o, 3o ausgebildet ist. Das Verhaken der ineinander verzahnten Rauigkeitsspitzen von Bauelementoberfläche 2o, 3o und angrenzender Schicht des Prepregs 5 erklärt die ausgezeichnete Haftung von Bauelement 2, 3 und Prepreg 5.

Durch die erfindungsgemäße Verbesserung können Bauelemente 2, 3 problemlos in die Innenlagen von Leiterplattenelementen 1 integriert werden, ohne dass Delaminationen oder Rissbildungen und damit Funktionsausfälle des Leiterplattenelements 1 befürchtet werden müssen. Dies gilt insbesondere auch für Hochtemperaturanwendungen, wie Automobilelektronik oder Solartechnik, wo die Verbindung zwischen der Oberfläche 2o, 3o des eingebetteten Bauelements 2, 3 und dem umgebenden Prepreg 5 aufgrund der unterschiedlichen thermischen Ausdehnungskoeffizienten beider Materialien immer wiederkehrenden starken Belastungen ausgesetzt wird.

Die vorliegende Erfindung trägt somit zum einen zu einer weiteren Erhöhung der Integrationsdichte von Bauelementen 2, 3 in Leiterplattenelementen 1 bei und vergrößert zum anderen das Einsatzspektrum solcher Leiterplattenelemente 1 bis hin zu Hochtemperaturanwendungen.

## Patentansprüche

1. Verfahren zur Herstellung eines Leiterplattenelements (1), umfassend die folgenden Schritte:
a) Bereitstellen eines Leitungsdrahts (2) oder plattenförmigen Formteils (3) aus einem elektrisch leitenden Werkstoff,
b) Kontaktieren des Leitungsdrahts (2) oder plattenförmigen Formteils (3) mit einer elektrisch leitenden Folie (4) an wenigstens einer Kontaktstelle, wobei das Kontaktieren des Leitungsdrahts (2) oder plattenförmigen Formteils (3) mit der Folie (4) durch Schweißen erfolgt,
c) Aufbringen einer Deckschicht (5) auf die den Leitungsdraht (2) oder das plattenförmige Formteil (3) kontaktierende Seite (4a, 4b) der Folie (4),
**dadurch gekennzeichnet, dass**
die Oberfläche (2o, 3o) des Leitungsdrahts (2) oder plattenförmigen Formteils (3) vor dem Schritt c) zumindest teilweise aufgeraut wird und die Deckschicht (5) im Schritt c) mit der aufgerauten Oberfläche (2o, 3o) des Leitungsdrahts (2) oder plattenförmigen Formteils (3) in Kontakt gebracht wird.

2. Verfahren nach Anspruch 1, **dadurch gekennzeichnet, dass** das Aufrauen der Oberfläche (2o, 3o) des Leitungsdrahts (2) oder plattenförmigen Formteils (3) vor dem Kontaktieren des Leitungsdrahts (2) oder plattenförmigen Formteils (3) mit der Folie (4) gemäß Schritt b) erfolgt.

3. Verfahren nach Anspruch 1 oder 2, **dadurch gekennzeichnet, dass** die Oberfläche (2o, 3o) des Leitungsdrahts (2) oder plattenförmigen Formteils (3) durch chemisches Ätzen aufgeraut wird, wobei das chemische Ätzen vorzugsweise durch Eintauchen des Leitungsdrahts (2) oder plattenförmigen Formteils (3) in eine das Material des Leitungsdrahts (2) oder plattenförmigen Formteils (3) ätzende Flüssigkeit oder durch das Besprühen des Leitungsdrahts (2) oder plattenförmigen Formteils (3) mit einer solchen Flüssigkeit erfolgt.

4. Verfahren nach Anspruch 1 oder 2, **dadurch gekennzeichnet, dass** die Oberfläche (2o, 3o) des Leitungsdrahts (2) oder plattenförmigen Formteils (3) durch mechanisches Bearbeiten, zum Beispiel durch Sandstrahlen oder durch das Aufsprühen von Bims- oder Quarzmehl unter hohem Druck, aufgeraut wird.

5. Verfahren nach einem der Ansprüche 1 bis 4, **dadurch gekennzeichnet, dass** das Kontaktieren des Leitungsdrahts (2) oder plattenförmigen Formteils (3) mit der Folie (4) gemäß Schritt b) durch Widerstandsschweißen erfolgt.

6. Verfahren nach einem der Ansprüche 1 bis 5, **dadurch gekennzeichnet, dass** das Aufbringen einer Deckschicht (5) auf die den Leitungsdraht (2) oder das plattenförmige Formteil (3) kontaktierende Seite (4a, 4b) der Folie (4) gemäß Schritt c) durch Verpressen der Seite (4a, 4b) der Folie (4) mit einem Prepreg (5) aus Isolierstoffmasse erfolgt.

7. Verfahren nach Anspruch 6, **dadurch gekennzeichnet, dass** im Schritt c) eine Mehrzahl von elektrisch leitfähigen Folien (4), von denen mindestens eine mit mindestens einem Leitungsdraht (2) oder einem plattenförmigen Formteil (3) aus einem elektrisch leitenden Werkstoff kontaktiert ist, und eine Mehrzahl von jeweils zwischen den Folien eingefügten Prepregs (5) aus Isolierstoffmasse miteinander zu einem Mulitlayer-Leiterplattenelement (1) verpresst werden.

8. Leiterplattenelement, umfassend:
- zumindest eine elektrisch leitende Folie (4),
- zumindest eine Deckschicht (5), die die Folie (4) auf zumindest einer Seite (4a, 4b) abdeckt,
- zumindest einen Leitungsdraht (2) oder zumindest ein plattenförmiges Formteil (3) aus einem elektrisch leitenden Werkstoff, wobei der Leitungsdraht (2) oder das plattenförmige Formteil (3) an wenigstens einer Kontaktstelle mit der Folie (4) verschweißt ist und zumindest abschnittsweise, vorzugsweise vollständig, in die Deckschicht (5) eingebettet ist,
**dadurch gekennzeichnet, dass**
zumindest ein Teil der mit der Deckschicht (5) in Kontakt stehenden Oberfläche (2o, 3o) des Leitungsdrahts (2) oder plattenförmigen Formteils (3) aufgeraut ist.

9. Leiterplattenelement nach Anspruch 8, **dadurch gekennzeichnet, dass** der Leitungsdraht (2) vorzugsweise aus Kupfer besteht und mit einem kreisförmigen oder rechteckförmigen Querschnitt ausgebildet ist.

10. Leiterplattenelement nach Anspruch 8 oder 9, **dadurch gekennzeichnet, dass** das plattenförmige Formteil (3) aus Kupfer besteht.

## Claims

1. A method of producing a circuit board element (1) comprising the following steps:
a) providing a conducting wire (2) or a plate-like shaped part (3) consisting of an electrically conductive material,
b) contacting the conducting wire (2) or the plate-like shaped part (3) with an electrically conductive foil (4) at at least one contact point, the contacting of the conducting wire (2) or of the plate-like shaped part (3) with the foil (4) being executed by welding,
c) applying a cover layer (5) to the side (4a, 4b) of the foil (4) contacting the conducting wire (2) or the plate-like shaped part (3),
**characterized in that**
the surface (2o, 3o) of the conducting wire (2) or of the plate-like shaped part (3) is at least partially roughened prior to step c), and that the cover layer (5) is brought into contact with the roughened surface (2o, 3o) of the conducting wire (2) or of the plate-like shaped part (3) in step c).

2. The method according to claim 1, **characterized in that** roughening of the surface (2o, 3o) of the conducting wire (2) or of the plate-like shaped part (3) takes place prior to contacting the conducting wire (2) or the plate-like shaped part (3) with the foil (4) according to step b).

3. The method according to claim 1 or 2, **characterized in that** the surface (2o, 3o) of the conducting wire (2) or of the plate-like shaped part (3) is roughened by chemical etching, said chemical etching being preferably executed by immersing the conducting wire (2) or the plate-like shaped part (3) into a liquid etching the material of the conducting wire (2) or of the plate-like shaped part (3) or by spraying such a liquid onto the conducting wire (2) or the plate-like shaped part (3).

4. The method according to claim 1 or 2, **characterized in that** the surface (2o, 3o) of the conducting wire (2) or of the plate-like shaped part (3) is roughened by mechanical processing, e.g. by sand blasting or by spraying on pumice or quartz powder under high pressure.

5. The method according to one of the claims 1 to 4, **characterized in that** contacting of the conducting wire (2) or of the plate-like shaped part (3) with the foil (4) according to step b) is executed by resistance welding.

6. The method according to one of the claims 1 to 5, **characterized in that** the application of a cover layer (5) to the side (4a, 4b) of the foil (4) contacting the conducting wire (2) or the plate-like shaped part (3) according to step c) is executed by press-bonding the side (4a, 4b) of the foil (4) with a prepreg (5) made of an insulating material compound.

7. The method according to claim 6, **characterized in that** in step c) a plurality of electrically conductive foils (4), at least one of which has been contacted with at least one conducting wire (2) or a plate-like shaped part (3) made of an electrically conductive material, and a plurality of prepregs (5) made of an insulating material compound and inserted between the respective foils are pressed-bonded so as to form a multilayer circuit board element (1).

8. A circuit board element, comprising
- at least one electrically conductive foil (4),
- at least one cover layer (5), which covers the foil (4) on at least one side (4a, 4b) thereof,
- at least one conducting wire (2) or at least one plate-like shaped part (3) made of an electrically conductive material, the conducting wire (2) or the plate-like shaped part (3) being welded to the foil (4) at at least one contact point and being embedded in the cover layer (5), at least in certain areas thereof, preferably in full area,
**characterized in that**
at least a part of the surface (2o, 3o) of the conducting wire (2) or of the plate-like shaped part (3) that contacts the cover layer (5) is roughened.

9. The circuit board element according to claim 8, **characterized in that** the conducting wire (2) is preferably made of copper and is circular or rectangular in cross-section.

10. The circuit board element according to claim 8 or 9, **characterized in that** the plate-like shaped part (3) is made of copper.

## Revendications

1. Procédé pour la fabrication d'un élément de plaque de circuit imprimé (1) comprenant les étapes suivantes :
a) fourniture et préparation d'un fil conducteur (2) ou d'une pièce de forme (3) en forme de plaque en un matériau électriquement conducteur,
b) mise en contact du fil conducteur (2) ou de la pièce de forme (3) en forme de plaque avec une feuille (4) électriquement conductrice, au niveau d'au moins une zone de contact, la mise en contact du fil conducteur (2) ou de la pièce de forme (3) en forme de plaque avec la feuille (4) s'effectuant par soudage,
c) application d'une couche de recouvrement (5) sur le côté (4a, 4b) de la feuille (4), qui est en contact avec le fil conducteur (2) ou la pièce de forme (3) en forme de plaque,
**caractérisé**
**en ce que** la surface extérieure (20, 30) du fil conducteur (2) ou de la pièce de forme (3) en forme de plaque est rendue au moins partiellement rugueuse avant l'étape c), et la couche de recouvrement (5) est amenée, dans l'étape c), en contact avec la surface (20, 30) ayant été rendue rugueuse, du fil conducteur (2) ou de la pièce de forme (3) en forme de plaque.

2. Procédé selon la revendication 1, **caractérisé en ce que** l'opération permettant de rendre rugueuse la surface extérieure (20, 30) du fil conducteur (2) ou de la pièce de forme (3) en forme de plaque, est effectuée avant la mise en contact du fil conducteur (2) ou de la pièce de forme (3) en forme de plaque avec la feuille (4), conformément à l'étape b).

3. Procédé selon la revendication 1 ou la revendication 2, **caractérisé en ce que** la surface extérieure (20, 30) du fil conducteur (2) ou de la pièce de forme (3) en forme de plaque est rendue rugueuse par attaque chimique, l'attaque chimique étant de préférence effectuée en plongeant le fil conducteur (2) ou la pièce de forme (3) en forme de plaque dans un liquide attaquant le matériau du fil conducteur (2) ou la pièce de forme (3) en forme de plaque, ou bien en aspergeant le fil conducteur (2) ou la pièce de forme (3) en forme de plaque avec un tel liquide.

4. Procédé selon la revendication 1 ou la revendication 2, **caractérisé en ce que** la surface extérieure (20, 30) du fil conducteur (2) ou de la pièce de forme (3) en forme de plaque est rendue rugueuse par usinage mécanique, par exemple par sablage ou par pulvérisation de poudre de ponce ou de quartz, sous haute pression.

5. Procédé selon l'une des revendications 1 à 4, **caractérisé en ce que** la mise en contact du fil conducteur (2) ou de la pièce de forme (3) en forme de plaque avec la feuille (4) conformément à l'étape c), s'effectue par soudage par résistance.

6. Procédé selon l'une des revendications 1 à 5, **caractérisé en ce que** l'application d'une couche de recouvrement (5) sur le côté (4a, 4b) de la feuille (4), qui est en contact avec le fil conducteur (2) ou la pièce de forme (3) en forme de plaque conformément à l'étape c), est effectuée par pressage du côté (4a, 4b) de la feuille (4) avec un pré-imprégné ou prépreg (5) en une masse de matériau isolant.

7. Procédé selon la revendication 6, **caractérisé en ce que** dans l'étape c), une pluralité de feuilles électriquement conductrices (4), dont l'une au moins est en contact avec au moins un fil conducteur (2) ou une pièce de forme (3) en forme de plaque en un matériau électriquement conducteur, et une pluralité de prépregs (5) en une masse de matériau isolant insérés respectivement entre les feuilles, sont compressés ensemble par pressage réciproque pour former un élément de plaque de circuit imprimé (1) multicouches (Multilayer).

8. Elément de plaque de circuit imprimé comprenant :
- au moins une feuille (4) électriquement conductrice,
- au moins une couche de recouvrement (5), qui recouvre la feuille (4) sur au moins un côté (4a, 4b),
- au moins un fil conducteur (2) ou une pièce de forme (3) en forme de plaque en un matériau électriquement conducteur, le fil conducteur (2) ou la pièce de forme (3) en forme de plaque étant soudé à la feuille (4) au niveau d'au moins une zone de contact, et est au moins partiellement, de préférence totalement, noyé dans la couche de recouvrement (5),
**caractérisé**
**en ce qu'**au moins une partie de la surface extérieure (20, 30) du fil conducteur (2) ou de la pièce de forme (3) en forme de plaque, qui est en contact avec la couche de recouvrement (5), a été rendue rugueuse.

9. Elément de plaque de circuit imprimé selon la revendication 8, **caractérisé en ce que** le fil conducteur (2) est de préférence constitué de cuivre et est réalisé avec une section transversale de forme circulaire ou de forme rectangulaire.

10. Elément de plaque de circuit imprimé selon la revendication 8 ou la revendication 9, **caractérisé en ce que** la pièce de forme (3) en forme de plaque est constituée de cuivre.
